# EUROPÄISCHE PATENTSCHRIFT

(11) **EP 2 823 505 B1**
(45) Veröffentlichungstag und Bekanntmachung des Hinweises auf die Patenterteilung: **02.01.2019**
(21) Anmeldenummer: 13712158.8
(22) Anmeldetag: 05.03.2013
(51) Int. Cl.: H01L 21/225, H01L 31/18, H01L 31/0216

(54) **VERFAHREN ZUM ERZEUGEN EINES DOTIERBEREICHES IN EINER HALBLEITERSCHICHT**
METHOD FOR PRODUCING A DOPED REGION IN A SEMICONDUCTOR LAYER
PROCÉDÉ DE RÉALISATION D'UNE ZONE DOPÉE DANS UNE COUCHE DE SEMI-CONDUCTEUR

(30) Priorität: 05.03.2012 DE 102012203445
(43) Veröffentlichungstag der Anmeldung: 14.01.2015
(73) Patentinhaber: Fraunhofer Gesellschaft zur Förderung der angewandten Forschung e.V., 80686 München (DE)
(72) Erfinder: SEIFFE, Johannes, 79112 Freiburg (DE); RENTSCH, Jochen, 79312 Emmendingen (DE); HOFMANN,Marc, 79279 Vörstetten (DE); TROGUS, Daniel, 79110 Freiburg (DE); PILLATH, Florian, 96163 Gundelsheim (DE)
(74) Vertreter: Lemcke, Brommer & Partner Patentanwälte Partnerschaft mbB
(86) Internationale Anmeldenummer: PCT/EP2013/054317
(87) Internationale Veröffentlichungsnummer: WO 2013/131868

(56) Entgegenhaltungen:
- WO-A1-97/04480
- DE-A1- 19 813 188
- DE-A1-102010 024 308
- US-A- 4 101 351
- US-A- 4 104 091
- US-A1- 2012 187 539
- MA, Y.: "Industrial type PERC solar cell: Towards 80 micron thickness", THE COMPILED STATE-OF-THE-ART OF PV SOLAR TECHNOLOGY AND DEPLOYMENT : 23RD EUROPEAN PHOTOVOLTAIC SOLAR ENERGY CONFERENCE, EU PVSEC ; PROCEEDINGS OF THE INTERNATIONAL CONFERENCE, HELD IN VALENCIA, SPAIN, 1 - 5 SEPTEMBER 2008, WIP-RENEWABLE ENERGIES, D, 1. September 2008 (2008-09-01), XP040529167, ISBN: 978-3-936338-24-9
- JAN SCHMIDT ET AL: "Effective surface passivation of crystalline silicon using ultrathin Al 2 O 3 films and Al 2 O 3 /SiN x stacks", PHYSICA STATUS SOLIDI (RRL) - RAPID RESEARCH LETTERS, 17. September 2009 (2009-09-17), Seiten 287-289, XP055011115, ISSN: 1862-6254, DOI: 10.1002/pssr.200903272

## Beschreibung

Die Erfindung betrifft ein Verfahren zum Erzeugen eines Dotierbereiches in einer Halbleiterschicht gemäß Anspruch 1.

Typische Herstellungsprozesse von Halbleiterbauelementen umfassen Verfahrensschritte, bei welchen in einer Halbleiterschicht ein Dotierbereich erzeugt wird. Typischerweise weist hierbei die Halbleiterschicht einen ersten Dotierungstyp auf (p- oder n-Dotierung) und die Ausbildung des Dotierbereiches erfolgt mit einem Dotierstoff eines entgegengesetzten Dotierungstyps, sodass sich ein pn-Übergang in der Halbleiterschicht ausbildet. Ebenso ist es möglich, dass der Dotierbereich mit einem Dotierstoff des gleichen Dotierungstyps ausgebildet wird, sodass ein Hochdotierungsbereich in der Halbleiterschicht ausgebildet wird, beispielsweise um eine Passivierung der Oberfläche durch Senken der effektiven Oberflächen-Rekombinationsgeschwindigkeit für Minoritäts-Ladungsträger zu bewirken.

Solche Dotierbereiche in Halbleiterschichten werden bei vielfältigen Halbleiterbauelementen benötigt. Insbesondere bei der Herstellung fotovoltaischer Solarzellen ist ein großflächiges Erzeugen eines Dotierbereiches notwendig.

Aus DE 198 13 188 A1 ist ein Verfahren zur einseitigen Dotierung von Halbleiterkörpern bekannt. Hierbei wird zunächst eine herkömmliche Oxidschicht sowohl auf der zu dotierenden Seite als auch auf der nicht zu dotierenden Seite eines Substrates aufgebracht. Anschließend wird eine den Dotierstoff enthaltende Dotierschicht auf der Oxidschicht der zu dotierenden Seite aufgebracht. In einem Diffusionsschritt tritt der Dotierstoff zunächst gleichmäßig durch die zwischen Substrat und Dotierschicht liegende Oxidschicht hindurch, und dringt dann in das Substrat ein und bewirkt eine gleichmäßige Dotierung.

Typische Herstellungsprozesse zum Erzeugen des pn-Übergangs in kristallinen Silizium-Solarzellen sehen daher die Diffusion eines Emitters mittels Phosphor als Dotierstoff vor, wobei typischerweise die Halbleiterschicht als Bor-dotiertes p-Typ-Silizium ausgebildet ist. Die Diffusion vollzieht sich bei typischen Prozessen aus einer phosphorhaltigen Siliziumoxidschicht, dem sogenannten Phosphorsilikatglas (PSG). Das Phosphorsilikatglas kann beispielsweise in einer POCl₃-Atmosphäre bei hohen Temperaturen aufgewachsen werden oder durch vorheriges Aufsprühen von Phosphorsäure auf die Halbleiterschicht entstehen. Solche Verfahren sind beispielsweise aus Nakano, K., et al. "Development of a novel phosphorus spray diffusion system for low cost silicon solar cells" in 12th Workshop on Crystalline Silicon Solar Cell Materials and Processes. 2002. Denver, Colorado, USA bekannt.

Ebenso ist es bekannt, PSG mittels anderer CVD (Chemical Vapour Deposition)-Verfahren abzuscheiden, wie beispielsweise in Sivoththaman, S., et al., "Selective emitters in Si by single step rapid thermal diffusion for photovoltaic devices."IEEE Electron Device Letters, 2000, 21(6): p. 274-6 und Benick, J., et al. PECVD PSG as a dopant source for industrial solar cells." In Proceedings of the 21st European Photovoltaic Solar Energy Conference. 2006. Dresden, Germany beschrieben.

Soll hingegen bei vertauschten Dotierungstypen, beispielsweise in einer Halbleiterschicht ausgebildet durch n-Typ-Silizium, ein Emitter mittels einer p-Diffusion erzeugt werden, so kann eine äquivalente Diffusion aus Bor-haltigen Siliziumoxid (BSG), das heißt mit Bor als Dotierstoff, verwendet werden.

Ebenso ist es bei Solarzellen bekannt, wie eingangs beschrieben, Dotierbereiche auszubilden, die den gleichen Typ wie die Basisdotierung der Halbleiterschicht aufweisen. Solche p⁺-p- bzw. n⁺-n-Übergänge verbessern typischerweise die Kontaktierbarkeit der Halbleiterschicht durch metallische Kontaktierungsstrukturen und außerdem wird das Spannungspotenzial der fotovoltaischen Solarzelle erhöht.

Bei diesem vorbekannten Verfahren muss jeweils nach der Diffusion das dotierte Silikatglas (PSG oder BSG) aufgrund der hygroskopischen Eigenschaften des Silikatglases in einem nasschemischen Prozess typischerweise unter Verwendung von schwach konzentrierter Flusssäure (HF) entfernt werden. Zur Oberflächenpassivierung wird typischerweise anschließend eine Passivierungsschicht aufgebracht, beispielsweise Siliziumoxid, Siliziumnitrid, amorphes Silizium, Siliziumcarbid, Aluminiumoxid oder Siliziumoxynitrid. Hierdurch wird eine Passivierungswirkung erzielt, da Oberflächendefekte durch das Entstehen von Bindungsorbitalen mit Atomen der Passivierungsschicht, deren Energieniveaus außerhalb der Bandlücke liegen, unschädlich gemacht werden, das heißt nicht mehr oder nur unwesentlich zur Oberflächenrekombination beitragen. Weiterhin können geladene Zustände entstehen, das heißt ortsfeste Ladungszentren, die durch das resultierende elektrische Feld das Ladungsgleichgewicht an der Oberfläche verschieben und so die Rekombinationsrate verringern.

Ebenso wurde versucht, die Schicht, welche als Dotierstoffquelle für die Diffusion dient, gleichzeitig als Passivierungsschicht auszubilden, wie beispielsweise in US 6,429,037 B1 beschrieben.

Der Erfindung liegt die Aufgabe zugrunde, einen kostengünstigen Herstellungsprozess zum Erzeugen eines Dotierbereiches in einer Halbleiterschicht mittels Diffusion eines Dotierstoffes bereitzustellen. Weiterhin soll der Prozess in kostengünstiger Weise eine Oberflächenpassivierung im Sinne einer Reduzierung der Oberflächenrekombinationsgeschwindigkeit für Minoritäts-Ladungsträger der Halbleiterschicht ermöglichen.

Gelöst ist diese Aufgabe durch ein Verfahren gemäß Anspruch 1. Vorteilhafte Ausgestaltungen finden sich in den Ansprüchen 2 - 14. Hiermit wird der Wortlaut sämtlicher Ansprüche per Referenz in die Beschreibung einbezogen.

Die Erfindung ist in der überraschenden Erkenntnis des Anmelders begründet, dass bei geeigneter Wahl ein Schichtsystem bestehend zumindest aus Passivierungsschicht und Dotierschicht derart ausgebildet werden kann, dass die Dotierung der Halbleiterschicht durch Anbringen von Dotierstoff aus der Dotierschicht durch die Passivierungsschicht hindurch in die Halbleiterschicht erfolgt und dennoch nach Abschluss des Dotiervorgangs an der Grenzfläche Halbleiterschicht/Passivierungsschicht eine Oberflächenpassivierung durch die Passivierungsschicht erzielt wird.

Das erfindungsgemäße Verfahren zum Erzeugen eines Dotierbereiches einer Halbleiterschicht einer fotovoltaischen Solarzelle umfasst einen Verfahrensschritt A, in welchem eine Dotierschicht auf die Halbleiterschicht aufgebracht wird. Die Dotierschicht enthält mindestens einen Dotierstoff zum Erzeugen des Dotierbereiches.

In einem Verfahrensschritt B erfolgt das Eindiffundieren des Dotierstoffes in die Halbleiterschicht durch Wärmeeinwirkung.

Dies entspricht den aus dem Stand der Technik bekannten Prozessen zum Erzeugen eines Dotierbereiches in einer Halbleiterschicht durch Eindiffundieren eines Dotierstoffes in die Halbleiterschicht.

Wesentlich ist, dass bei dem erfindungsgemäßen Verfahren vor Verfahrensschritt A in einem Verfahrensschritt A0 eine Passivierungsschicht mittelbar oder unmittelbar auf eine Oberfläche der Halbleiterschicht aufgebracht wird. Im Verfahrensschritt A wird bei dem erfindungsgemäßen Verfahren somit die Dotierschicht mittelbar oder unmittelbar auf die Passivierungsschicht aufgebracht und in Verfahrensschritt B wird der Dotierstoff aus der Dotierschicht durch die Passivierungsschicht hindurch in die Halbleiterschicht eindiffundiert.

Die Passivierungsschicht wird mittels mindestens eines chemischen und/oder physikalischen Abscheideverfahrens aufgebracht. Der Dotierstoff ist ein Dotierstoff aus der Gruppe Bor, Phosphor, Gallium, Arsen oder Indium. Die Passivierungsschicht wird in Verfahrensschritt A0 mit einer Dotierstoffkonzentration kleiner 5x10¹⁹ cm⁻³, bevorzugt kleiner 10¹⁹ cm⁻³ und die Dotierschicht in Verfahrensschritt A mit einer Dotierstoffkonzentration größer 10²⁰ cm⁻³, bevorzugt größer 10²¹ cm⁻³ ausgebildet.

Die Bezeichnung "Dotierstoff" bezieht sich hierbei auf Dotierstoffe zum Erzeugen eines p- oder n-dotierten Bereiches, das heißt solche Dotierstoffe, welche bei Eindringen in die Halbleiterschicht ein Energieniveau innerhalb der Bandlücke ausbilden.

Überraschenderweise wird mit dem erfindungsgemäßen Verfahren auf der Halbleiterschicht eine Schichtstruktur umfassend zumindest die Passivierungsschicht und die Dotierschicht ausgebildet, welche einerseits eine Ausbildung des Dotierbereiches in der Halbleiterschicht und des Durchdringens des Dotierstoffes aus der Dotierschicht durch die Passivierungsschicht in die Halbleiterschicht ermöglicht und darüber hinaus die Passivierungswirkung der Passivierungsschicht nicht beeinträchtigt. Hierdurch ergibt sich insbesondere der Vorteil, dass die Dotierschicht nicht wieder entfernt werden muss, womit ein aufwendiger und kostenintensiver Prozessschritt entfällt.

Die Ausbildung der Passivierungsschicht erfolgt mittels eines chemischen und/oder physikalischen Abscheideverfahrens, d.h. insbesondere mittels eines aktiven, mittels Parametern kontrollierbaren Verfahrens und somit beispielweise nicht durch natürliche Oxidation in Umgebungsatmosphäre bei Raumtemperatur.

Untersuchungen des Anmelders haben ergeben, dass zur Abscheidung der Passivierungsschicht insbesondere geeignet sind: ein chemisches Verfahren aus der Gruppe CVD (Chemical Vapor Deposition), ALD (Atomic Layer Deposition), Galvanik, Spin Coating, CSD (Chemical solution deposition) oder ein physikalisches Verfahren aus der Gruppe PVD (Physical Vapor Deposition), Sputtering, reaktives Sputtering, thermische Verdampfung, MBE (Molecular Beam Epitaxy), Electro-Spray Deposition.

Insbesondere vorteilhaft ist die Verwendung eines Abscheideverfahrens aus der Gruppe CVD (insbesondere Plasma enhanced chemical vapor deposition PECVD), PVD zur Abscheidung der Passivierungsschicht. Hiermit konnten in Versuchen hohe Schichtqualitäten und -homogenitäten erzielt werden.

Vorzugsweise ist Verfahrensschritt B derart ausgebildet, dass die Passivierungsschicht, welche von dem Dotierstoff durchdrungen wird, nicht zerstört wird, so dass auch nach Abschluss von Verfahrensschritt B die Passivierungsschicht die Oberfläche der Halbleiterschicht passiviert, insbesondere auch in dem Bereich der Eindiffundierung. Verfahrensschritt B schließt in dieser vorzugsweisen Ausführungsform somit insbesondere zerstörende Verfahren, wie beispielsweise lokales Aufschmelzen zumindest der Dotierungs- und Passivierungsschicht mittels lokaler Erwärmung z.B. durch einen Laser aus.

Vorzugsweise sind Dotierstoff und Passivierungsschicht aus unterschiedlichen Materialien ausgebildet, sodass insbesondere eine Optimierung hinsichtlich der Passivierungswirkung durch die Passivierungsschicht ermöglicht wird.

Besonders kostengünstige Ausgestaltungen des erfindungsgemäßen Verfahrens ergeben sich, wenn die Dotierschicht als eine der Schichten Aluminiumoxidschicht, Siliziumoxidschicht, Siliziumnitridschicht, Aluminiumnitridschicht, Siliziumcarbidschicht, Siliziumoxynitridschicht oder amorphe Siliziumschicht ausgebildet ist.

Untersuchungen des Anmelders haben weiterhin ergeben, dass vorzugsweise die Dotierschicht mit einer Dicke im Bereich 1 nm - 1000 nm, bevorzugt im Bereich 10 nm - 300 nm ausgebildet wird. Hierdurch wird bei typischen Dotierstoffkonzentrationen eine ausreichende Dotierstoffquelle durch die Dotierschicht ausgebildet.

Die Passivierungsschicht ist vorzugsweise als Aluminiumoxid, Siliziumoxid, Siliziumnitrid, Aluminiumnitrid, Siliziumcarbid oder Siliziumoxynitrid ausgebildet. Hierdurch wird einerseits eine hochwertige Passivierungswirkung erzielt, andererseits können gängige Abscheideverfahren für solche Schichten an das erfindungsgemäße Verfahren angepasst werden.

Die Passivierungsschicht stellt eine wie vorgehend ausgeführt in einem Verfahrensschritt abgeschiedene Schicht dar. Sie unterscheidet sich somit beispielsweise von einem nativen Oxid, das heißt einer nativen Oxidschicht, welche sich bei Raumtemperatur und Umgebungsatmosphäre typischerweise auf Oberflächen von Halbleitern ausbildet. Die Passivierungsschicht gemäß des erfindungsgemäßen Verfahrens weist hingegen eine erheblich bessere Passivierungswirkung auf. Die Passivierungswirkung ist bereits bei sehr dünner Ausgestaltung der Passivierungsschicht gegeben. Die Passivierungsschicht ist vorzugsweise zumindest als geschlossene Atomlage mittelbar oder unmittelbar auf der Oberfläche der Halbleiterschicht ausgebildet. Untersuchungen des Anmelders haben gezeigt, dass die Dicke der Passivierungsschicht eine vorgegebene Obergrenze nicht überschreiten darf, um ein Durchdringen der Passivierungsschicht durch den Dotierstoff aus der Dotierschicht zu ermöglichen. Vorzugsweise ist die Passivierungsschicht daher mit einer Dicke < 500 nm, bevorzugt < 50 nm, insbesondere bevorzugt mit einer Dicke im Bereich 5 nm bis 10 nm ausgebildet.

Sofern die Passivierungsschicht mittelbar auf die Halbleiterschicht und/oder die Dotierstoffschicht mittelbar auf die Passivierungsschicht aufgebracht wird, weist vorzugsweise die Schichtstruktur zwischen Halbleiterschicht und Dotierschicht eine Gesamtdicke < 500 nm, bevorzugt < 50 nm, weiter bevorzugt < 10 nm auf, um ein Durchdringen der Schichtstruktur mittels des Dotierstoffes aus der Dotierschicht in die Halbleiterschicht zu ermöglichen.

Insbesondere ist es vorteilhaft, dass die Passivierungsschicht unmittelbar auf die Halbleiterschicht und/oder die Dotierschicht unmittelbar auf die Passivierungsschicht aufgebracht wird, vorzugsweise, dass beide vorgenannten Bedingungen zutreffen.

Ein wesentlicher Vorteil des erfindungsgemäßen Verfahrens ist, dass die Dotierschicht nicht von der Halbleiterschicht entfernt werden muss. Daher wird daher bei dem erfindungsgemäßen Verfahren die Dotierschicht in nachfolgenden Verfahrensschritten nicht wieder entfernt. Insbesondere wird die Dotierschicht als integraler Bestandteil einer auszubildenden Solarzelle ausgebildet.

Das erfindungsgemäße Verfahren weist weiterhin den Vorteil auf, dass zwischen Abscheiden der Passivierungsschicht und Abscheiden der Dotierschicht keine Prozessschritte wie beispielsweise nasschemische Prozessschritte notwendig sind. In einer vorzugsweisen Ausführungsform des erfindungsgemäßen Verfahrens erfolgt daher das Abscheiden von Passivierungs- und Dotierschicht in einer Prozesskammer in situ. Der Begriff "in situ" ist im Rahmen dieser Anmeldung derart zu verstehen, dass bei in situ ausgeführten Prozessschritten kein Ausschleusen aus der Prozesskammer des Halbleiterbauelementes zwischen den Prozessschritten erfolgt.

Insbesondere ist es vorteilhaft, dass in der Prozesskammer in situ zusätzlich mindestens eine Seite der Halbleiterschicht texturiert wird, insbesondere vor Abscheiden der Passivierungsschicht texturiert wird.

Auf diese Weise kann somit kostengünstig eine reflexionsmindernde Oberflächentextur erzeugt werden, eine Passivierungsschicht zur Verringerung der Oberflächenrekombinationsgeschwindigkeit abgeschieden und eine Dotierschicht zum Erzeugen eines Dotierbereiches in der Halbleiterschicht in situ in einer Prozesskammer ausgebildet werden.

Aufgrund der Ausbildung der Schichtstruktur bei dem erfindungsgemäßen Verfahren kann das Eindiffundieren im Verfahrensschritt B, das heißt das Eintreiben von Dotierstoff aus der Dotierschicht durch die Passivierungsschicht in die Halbleiterschicht, in Raumatmosphäre erfolgen. Vorzugsweise erfolgt daher in Verfahrensschritt B das Eindiffundieren in einem offenen System, insbesondere in einem Inline-Ofen. Es ist somit nicht notwendig, das Eindiffundieren unter einer kostenintensiveren Dotierstoffgasatmosphäre (wie z.B. POCl₃ oder BrCl₃) durchzuführen.

In einer weiteren vorzugsweisen Ausgestaltung des erfindungsgemäßen Verfahrens wird auf einer Vorder- und auf einer Rückseite der Halbleiterschicht jeweils im Verfahrensschritt A0 eine Passivierungsschicht und in Verfahrensschritt A eine Dotierschicht aufgebracht. Auf diese Weise kann so kostensparend auf beiden Seiten, und insbesondere vorzugsweise in situ, eine Schichtstruktur bestehend zumindest aus Passivierungsschicht und Dotierschicht gemäß des erfindungsgemäßen Verfahrens ausgebildet werden, wobei jeweils die Dotierschicht auf der der Halbleiterschicht abgewandten Seite der Passivierungsschicht angeordnet ist. Insbesondere ist es vorteilhaft, dass die Dotierschicht auf der Vorderseite und die Dotierschicht auf der Rückseite unterschiedliche Dotierstoffe aufweisen. Auf diese Weise kann kostengünstig, beispielsweise auf einer Vorderseite einer als Solarzelle ausgebildeten Halbleiterschicht, ein Emitter mit einem zu einem Basis-Dotierungstyp der Halbleiterschicht entgegengesetzten Dotierungstyp, ausgebildet werden und auf der Rückseite der Halbleiterschicht ein Hochdotierungsbereich, mit dem gleichen Dotierungstyp der Halbleiterschicht ausgebildet werden.

Das Eintreiben des Dotierstoffes in die Halbleiterschicht in Verfahrensschritt B kann in an sich bekannter Weise erfolgen, insbesondere bevorzugt durch globales Erwärmen der Schichtstruktur umfassend zumindest Halbleiterschicht, Passivierungsschicht und Dotierschicht, Dies kann in einem an sich bekannten Ofen, insbesondere wie zuvor ausgeführt in einem Inline-Ofen erfolgen.

Insbesondere ist es vorteilhaft, dass zusätzlich ein lokal selektives Eindiffundieren erfolgt, vorzugsweise durch lokales Erwärmen.

In dieser vorzugsweisen Ausführungsform wird somit einerseits durch das globale Erwärmen ein ganzflächiges Eintreiben des Dotierstoffes und somit ein ganzflächiges Ausbilden eines Dotierbereiches erzielt, Zusätzlich wird jedoch durch lokales Erwärmen an selektiven Bereichen, an welchen die lokale Erwärmung erfolgt, ein erhöhtes Maß an Dotierstoff aus der Dotierschicht durch die Passivierungsschicht in die Halbleiterschicht eingetrieben, sodass an diesen Stellen selektiv lokaler Erwärmung eine erhöhte Dotierstoffkonzentration in dem Halbleiter ausgebildet wird.

Dies ist insbesondere bei der Herstellung von fotovoltaischen Solarzellen vorteilhaft, um beispielsweise in den Bereichen, in welchen das Aufbringen einer metallischen Kontaktierungsstruktur auf die Oberfläche der Halbleiterschicht erfolgen soll, hochdotierte Bereiche auszubilden, um insbesondere den Kontaktwiderstand und die Rekombination an der Halbleiter/Metall-Schnittstelle zu verringern.

Vorzugsweise ist die Passivierungsschicht als Dielektrikum, insbesondere als amorphes Aluminiumoxid oder Siliziumoxid ausgebildet.

Vorzugsweise ist die Dotierstoffschicht wasserstoffhaltig mit einer Konzentration > 5 at.%, insbesondere > 10 at.%, um während der Erwärmung entstehende Defekte in der Passivierungsschicht oder an der Halbleiteroberfläche durch diesen Wasserstoff zu passivieren. Insbesondere ist die Dotierstoffschicht als wasserstoffhaltiges, amorphes Silizium oder wasserstoffhaltiges, amorphes Siliziumnitrid ausgebildet.

Das erfindungsgemäße Verfahren ist insbesondere bei der Herstellung von fotovoltaischen Solarzellen, insbesondere von fotovoltaischen Silizium-Solarzellen, welche aus den von einer Siliziumschicht als Basis, vorzugsweise einem Siliziumwafer, ausgebildet werden.

Bei dem erfindungsgemäßen Verfahrenwird die Schichtstruktur bestehend aus Passivierungsschicht und Dotierschicht angepasst, sodass sogleich die optischen Eigenschaften der Solarzelle verbessert werden, beispielsweise auf bei Benutzung der Solarzelle dem Lichteinfall zugewandten Vorderseite eine Antireflexionsschicht bilden und/oder auf der Rückseite die interne Reflexion verbessern.

Das erfindungsgemäße Verfahren bzw. vorzugsweise Ausführungsformen hiervon weisen folgende Vorteile auf:
Der Vorteil gegenüber herkömmlichen Prozessfolgen besteht darin, dass das Wiederabnehmen, insbesondere ein Rückätzen der Dotierschicht vor der Oberflächenpassivierung entfällt. Des Weiteren können die Abscheidungen der Passivierungsschicht und die Abscheidungen der Dotierschicht im gleichen Verfahren (zum Beispiel PECVD oder PVD) hintereinander ausgeführt werden. Somit ist insbesondere im Falle von Vakuumprozessen nur ein Ein- und Ausschleusevorgang notwendig. Weiterhin kann die eigentliche Hochtemperaturdiffusion zum Eintreiben des Dotierstoffes in die Halbleiterschicht ohne dotierstoffhaltige Atmosphäre und insbesondere in einem offenen System (zum Beispiel einem Inline-Ofen, wie zuvor ausgeführt) erfolgen.

Das Eintreiben des Dotierstoffes in Verfahrensschritt B erfolgt vorzugsweise bei Temperaturen im Bereich von 700°C bis 1500°C, insbesondere von 800°C bis 1000°C. Das Eintreiben erfolgt typischerweise für eine Zeitdauer im Bereich von 5 min bis 300 min, insbesondere 30 min bis 150 min..

Das erfindungsgemäße Verfahren ermöglicht die Verwendung von Vakuumprozessen, wie beispielsweise PECVD oder PVD zur Abscheidung der Dotierstoffquelle. Hierdurch ergeben sich Vorteile hinsichtlich der Homogenität und Einseitigkeit, gegenüber anderen Abscheideverfahren.

Bisher wurde jedoch auf das Abscheiden einer Dotierschicht mittels PECVD oder PVD verzichtet, da bei den bisherigen Prozessen jeweils ein zusätzlicher Vakuumschritt notwendig war und somit das Verfahren erheblich kostenintensiver.

Bei dem erfindungsgemäßen Verfahren kann das Abscheiden der Passivierungsschicht und Dotierschicht jedoch in situ erfolgen, sodass kein zusätzlicher Vakuumschritt notwendig ist. Es ist somit erstmals möglich, auf vorbekannte hochwertige Abscheideverfahren zum Erzeugen einer Dotierschicht mit großer Homogenität und Einseitigkeit zurückzugreifen, ohne dass hierdurch die Gesamtkosten des Verfahrens erheblich gesteigert werden.

Aufgrund der Einseitigkeit der vorgenannten Vakuumprozesse ergibt sich darüber hinaus die Möglichkeit, in einem Vakuumschritt direkt auf Vorder- und Rückseite eine entsprechende Schichtstruktur bestehend jeweils zumindest aus Passivierungsschicht und Dotierschicht abzuscheiden und nachfolgend in einem Verfahrensschritt B, das heißt einem gemeinsamen Hochtemperaturschritt, sowohl an der Vorderseite als auch an der Rückseite der Halbleiterschicht jeweils am Dotierbereich zu diffundieren.

Ein weiterer Vorteil ergibt sich dadurch, dass in möglicherweise bestehenden Löchern oder Rissen der Passivierungsschicht, während des Hochtemperaturprozesses im Verfahrensschritt B ein thermisches Oxid in den vorgenannten Löchern und Rissen aufwächst und somit eine bessere Isolierung gegenüber nachfolgender galvanischer Metallabscheidung gegeben ist.

Weiterhin kann, wie zuvor ausgeführt, eine Texturierung insbesondere zum Texturieren einer Vorderseite der Halbleiterschicht kostengünstig implementiert werden, indem in situ eine Texturierung mittels Plasmaverfahren und das Aufbringen von Passivierungsschichten und Dotierschichten einer Prozesskammer und einem Vakuumschritt erfolgt, sodass zur Ausbildung von Texturierungen, Passivierungsschicht und Dotierschicht nur ein Ein- und Ausschleuseprozess nötig ist.

Als Passivierungsschicht wird im Rahmen dieser Anmeldung eine Schicht bezeichnet, die die effektive Oberflächenrekombinationsgeschwindigkeit auch nach der Hochtemperatur dieser Diffusion im Verfahrensschritt B deutlich senkt. Vorzugsweise ist die Passivierungsschicht ausgebildet, sodass auch nach Verfahrensschritt B an der durch die Passivierungsschicht bedeckten Oberfläche der Halbleiterschicht eine effektive Rekombinationsgeschwindigkeit für Minoritäts-Ladungsträger < 500 cm/s, vorzugsweise < 50 cm/s gegeben ist.

Die Passivierungsschicht kann auch bereits nach der Abscheidung Dotierstoff enthalten, jedoch, wie eingangs erwähnt, in einer erheblich geringeren Menge verglichen mit der Dotierschicht. Aufgrund der Diffusion im Verfahrensschritt B wird die Passivierungsschicht typischerweise nach dem Hochtemperaturschritt Dotierstoff enthalten.

Vorzugsweise wird eine wasserstoffreiche Dotierstoffschicht verwendet, die während des globalen Erwärmens genügend Wasserstoff in die Passivierungsschicht eindiffundiert um die passivierende Wirkung dieser Schicht zu erhalten oder zu verbessern (durch Absättigen entstehender Defekte mit Wasserstoffatomen).

Vorzugsweise wird als Passivierungsschicht in Verfahrensschritt A0 amorphes Aluminiumoxid (a-AlOx) abgeschieden und in Verfahrensschritt A eine sehr wasserstoffreiche Dotierstoffschicht wie amorphes, wasserstoffhaltiges Silizium (a-Si:H) abgeschieden, wobei der während des Erwärmens in Verfahrensschritt B mobil werdende Wasserstoff im a-AlOx die bei hohen Temperaturen (über ca 800 °C) auftretende Kristallisation verhindert und so die außerordentliche Passivierqualität amorphen Aluminiumoxids erhält.

Vorzugsweise wird in Verfahrensschritt A0 ein abgeschiedenes, insbesondere leicht mit Phosphor versetztes Siliziumoxid als Passivierungsschicht verwendet und in Verfahrensschritt A ein phosphorhaltiges, wasserstoffhaltiges Siliziumnitrid verwendet, wobei der während des Erwärmens in Verfahrensschritt B mobil werdende Wasserstoff im Siliziumoxid und an der Oberfläche der Halbleiterschicht offene Atombindungen absättigt und somit die Oberflächenpassivierung erhält oder verbessert

Vorzugsweise wird die strukturelle Zusammensetzung sowie die Schichtdicken der Passivierungsschicht und der Dotierstoffschicht so angepasst, derart, dass sie nach der hohen Temperatur in Verfahrensschritt B eine optische Funktion als Antireflexionsschicht oder als interner Reflektor zur Verminderung von aus der Halbleiterschicht austretendem Licht erfüllen.

Vorzugsweise erfolgt das Eindiffundieren in Verfahrensschritt B in einem geschlossenen System, insbesondere bevorzugt in einem Rohrofen.

Es liegt im Rahmen des erfindungsgemäßen Verfahrens, weitere Schichten aufzubringen, insbesondere eine Deckschicht auf der der Passivierungsschicht abgewandten Seite der Dotierungsschicht.

Weitere vorzugsweise Merkmale und Ausgestaltungen des erfindungsgemäßen Verfahrens werden nachfolgend anhand der Figuren und von Ausführungsbeispielen erläutert. Dabei zeigt:
- Figur 1: eine Gegenüberstellung eines vorbekannten Verfahrens (a) zum Ausbilden eines Dotierbereiches in einer Halbleiterschicht mit einem ersten Ausführungsbeispiel des erfindungsgemäßen Verfahrens (b);
- Figur 2: einen schematischen Ablauf eines zweiten Ausführungsbeispiels des erfindungsgemäßen Verfahrens zur Ausbildung eines Dotierbereiches von einer Vorderseite einer Halbleiterschicht und
- Figur 3: eine schematische Darstellung eines dritten Ausführungsbeispiels des erfindungsgemäßen Verfahrens zur Ausbildung eines Dotierbereiches sowohl an einer Vorder- als auch einer Rückseite einer Halbleiterschicht.

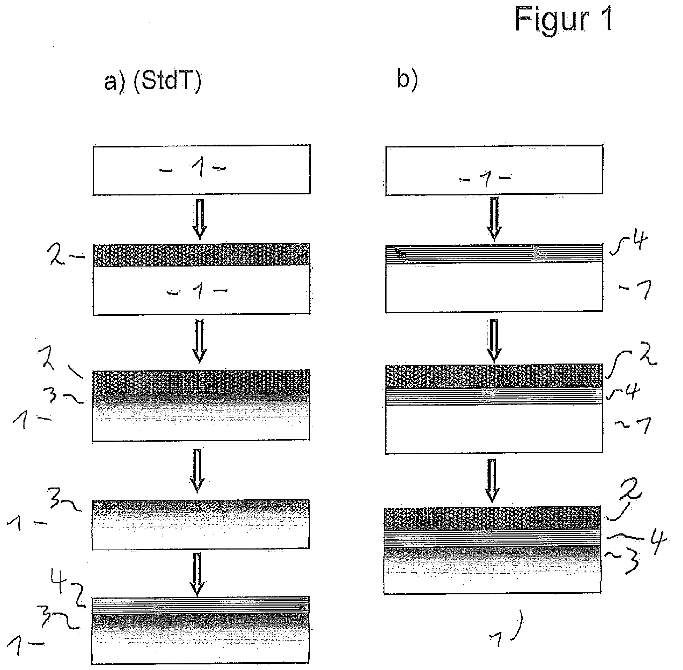

Die in den Figuren 1 - 3 dargestellten Ausführungsbeispiele stellen jeweils Verfahren bzw. Teile von Verfahren zur Herstellung einer fotovoltaischen Silizium-Solarzelle dar. Ebenso könnten mit den dargestellten Verfahren jedoch auch andere Halbleiterbauelemente, insbesondere OLEDs oder Displays hergestellt werden.

In den Figuren bezeichnen gleiche Bezugszeichen gleiche oder gleich wirkende Elemente.

Bei einem aus dem Stand der Technik vorbekannten Verfahren gemäß Figur 1a) wird eine Halbleiterschicht bereitgestellt, welche als Siliziumwafer 1 mit einer p-Basis-Dotierung ausgebildet ist.

Mittels CVD oder Spray-on wird eine Dotierungsschicht 2 aufgebracht, welche in diesem Ausführungsbeispiel als Phosphorsilikatglas ausgebildet ist.

Anschließend erfolgt in einem Hochtemperaturschritt die Diffusion eines Dotierbereiches 3 in diesem Ausführungsbeispiel an der Vorderseite des Siliziumwafers 1.

Aufgrund des Dotierstoffes Phosphor, welcher aus der Dotierschicht durch die Hochtemperaturdiffusion in den Siliziumwafer 1 eindringt, wird somit an der Vorderseite ganzflächig ein n-dotierter Emitter ausgebildet.

Anschließend erfolgt ein Rückätzen, das heißt ein Entfernen der Dotierschicht 2 in einem nasschemischen Ätzverfahren.

In einem weiteren Verfahrensschritt erfolgt mittels CVD oder PVD ein Aufbringen einer Passivierungsschicht 4, welche in diesem Ausführungsbeispiel als Siliziumnitrid ausgebildet ist.

Bei dem erfindungsgemäßen Verfahren gemäß des ersten Ausführungsbeispiels, wie in Figur 1b dargestellt, wird hingegen auf dem Siliziumwafer 1 zunächst (in einem Verfahrensschritt A0) mittels CVD oder PVD eine Passivierungsschicht 4 aufgebracht, welche in diesem ersten Ausführungsbeispiel des erfindungsgemäßen Verfahrens als Siliziumoxid ausgebildet ist.

Anschließend wird (in einem Verfahrensschritt A) mittels CVD oder PVD eine Dotierschicht 2 aufgebracht, welche in diesem ersten Ausführungsbeispiel als phosphorhaltiges Siliziumnitrid ausgebildet ist.

Das Aufbringen der Passivierungsschicht 4 und der Dotierschicht 2 erfolgt in situ in einem Vakuumprozessschritt, das heißt, ohne dass zwischen dem Aufbringen der beiden Schichten ein Ausschleusevorgang notwendig ist.

Anschließend erfolgt die Diffusion mittels Hochtemperaturschritt in einem Inline-Ofen bei einer Temperatur von 950 °C für eine Zeitdauer von 75 min, sodass sich ein Dotierbereich 3 an der Vorderseite des Siliziumwafers 1, auch in diesem Fall ein n-dotierter Emitter, ausbildet.

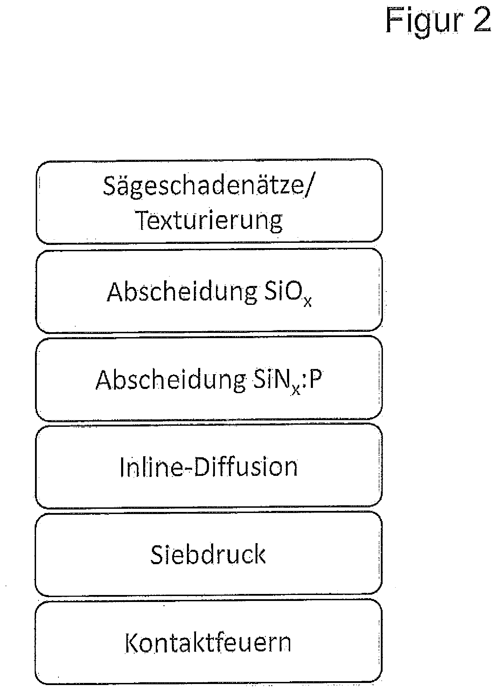

In Figur 2 ist ein weiteres Ausführungsbeispiel des erfindungsgemäßen Verfahrens zur Ausbildung eines Dotierbereiches an einer Vorderseite einer Halbleiterschicht schematisch dargestellt:
Die Halbleiterschicht stellt hierbei die Vorstufe einer Solarzelle mit p-Typ-Basis dar. Auf der Vorderseite dieser Solarzelle (bzw. deren Vorstufe) soll eine entsprechende Schichtstruktur, umfassend eine Passivierungsschicht und eine Dotierschicht gleichzeitig als Antireflexionsschicht zur Erhöhung der Lichteinkopplung verwendet werden.

Als Dotierstoffquelle wird in diesem Fall ein Phosphor-dotiertes Siliziumnitrid (SiNx:P) verwendet. Als Passivierungsschicht wird ein Siliziumoxid (SiOx) mit einer Dicke von 15 nm verwendet. Ebenso wäre die Verwendung eines Aluminiumoxids denkbar.

Gemäß Figur 2 erfolgt zunächst ein Abätzen des Sägeschadens und eine Texturierung des Siliziumwafers. Anschließend wird die als Siliziumoxidschicht ausgebildete Passivierungsschicht abgeschieden. Danach wird die als Siliziumnitridschicht, welche Phosphor als Dotierstoff enthält, ausgebildete Dotierschicht abgeschieden. Schließlich erfolgt in einem Inline-Ofen die Diffusion des Phosphors in den Siliziumwafer.

Anschließend erfolgt ein Aufbringen von Paste im Siebdruckverfahren, welche Paste in an sich bekannter Weise Metallpartikel und Glassplitter enthält, um anschließend in einem weiteren Temperaturschritt, dem sogenannten Kontakt-Feuern, ein Ausbilden einer metallischen Kontaktstruktur zu erwirken, welche aufgrund der Glasfritte die Dotierschicht und Passivierungsschicht durchdringt und einen elektrischen Kontakt mit dem Siliziumwafer ausbildet.

In einer bevorzugten Ausgestaltung des zweiten Ausführungsbeispiels kann nach der Inline-Diffusion zum Beispiel durch lokale Erwärmung mittels eines Lasers eine zusätzliche lokale Diffusion von Dotierstoff an denjenigen Stellen, an denen nachfolgend die metallischen Kontaktierungsstrukturen ausgebildet werden, erwirkt werden.

Die zusätzliche lokale Erwärmung mittels des Lasers führt somit zu einem zusätzlichen Eindiffundieren von Dotierstoff aus der Dotierschicht durch die Passivierungsschicht in die Halbleiterschicht, sodass an denjenigen Stellen, an welchen die lokale Erwärmung erfolgt, hochdotierte Bereiche in der Halbleiterschicht, das heißt in diesem Fall dem Siliziumwafer, oberflächennah ausgebildet werden, sodass insbesondere der Kontaktwiderstand zu den metallischen Kontaktierungsstrukturen verringert werden kann.

Durch das lokale Erwärmen mittels eines Lasers wird weiterhin selektiv in den lokal erwärmten Bereichen die Schichtstruktur bestehend aus zumindest Passivierungsschicht und Dotierschicht entfernt, sodass bereits eine selektive Öffnung dieser Schichtstruktur erfolgt. Daher ist es in diesem Fall nicht notwendig, dass die verwendete Paste Glasfritte enthält, da die Paste in dem Kontakt-Feuerungsschritt keine Dotierschicht und keine Passivierungsschicht mehr durchdringen muss. Es kann somit frittenfreie Siebdruckpaste verwendet werden oder die Ausbildung der metallischen Kontaktierungsstruktur kann mit an sich bekannten galvanischen Metallisierungsprozessen erfolgen.

Des Weiteren kann bei dem zweiten Ausführungsbeispiel das auf der Rückseite in dem Hochtemperaturschritt gewachsene Siliziumoxid als Rückseitenpassivierung verwendet werden, um eine lokal kontaktierte Rückseite, beispielsweise nach dem an sich bekannten PERC-Konzept, zu erzeugen.

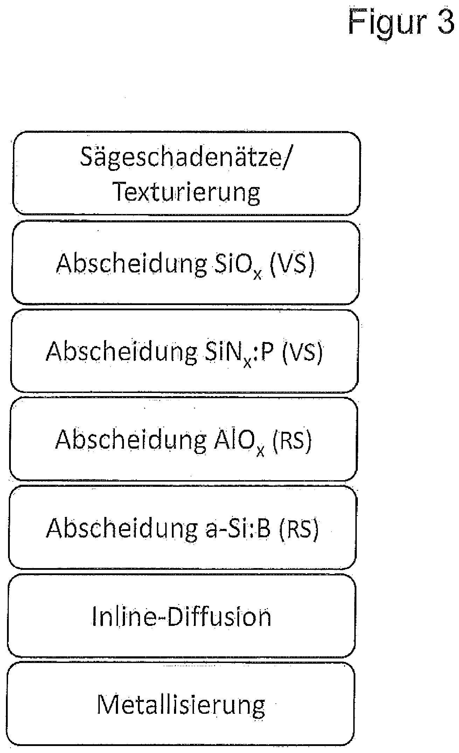

Figur 3 zeigt eine schematische Darstellung eines dritten Ausführungsbeispiels des erfindungsgemäßen Verfahrens.

Bei dem dritten Ausführungsbeispiel lässt sich der Vorteil der vorliegenden Erfindung bei gleichzeitiger Anwendung auf Vorder- und Rückseite der Halbleiterschicht nutzen. Wie in Figur 3 ersichtlich, erfolgt zunächst eine Sägeschadenätze und/oder eine Texturierung einer Halbleiterschicht, welche auch in diesem Ausführungsbeispiel als Siliziumwafer ausgebildet ist.

Anschließend erfolgen in situ folgende Verfahrensschritte:
- Abscheiden einer Passivierungsschicht (vorliegend SiOx) auf der Vorderseite;
- Abscheiden einer Dotierschicht (SiNx:P) auf der Vorderseite;
- Abscheiden einer Passivierungsschicht (AlOx) auf der Rückseite und
- Abscheiden einer Dotierschicht (a-Si:B) auf der Rückseite.

Die vorderseitige Dotierschicht weist somit Phosphor und die rückseitige Dotierschicht Bor als Dotierstoff auf.

Anschließend erfolgt der Hochtemperaturschritt mittels Inline-Diffusion, sodass gleichzeitig an der Vorderseite ein Phosphor-dotierter Bereich und an der Rückseite ein Bor-dotierter Bereich in dem Siliziumwafer ausgebildet wird.

Schließlich erfolgt eine Metallisierung, das heißt das Ausbilden metallischer Kontaktierungsstrukturen, welche beispielsweise analog zu dem zweiten Ausführungsbeispiel erfolgen kann.

Mit dem erfindungsgemäßen Verfahren sind somit in kostengünstiger Weise insbesondere hocheffiziente fotovoltaische Solarzellen herstellbar, insbesondere dadurch, dass ohne erhebliche Kostensteigerung auf PECVD-Verfahren zur Ausbildung der Passivierungsschicht und Dotierschicht zurückgegriffen werden kann.

## Patentansprüche

1. Verfahren zum Erzeugen eines Dotierbereiches (3) in einer Halbleiterschicht einer fotovoltaischen Solarzelle,
folgende Verfahrensschritte umfassend:
A Aufbringen einer Dotierschicht auf die Halbleiterschicht, welche Dotierschicht mindestens einen Dotierstoff zum Erzeugen des Dotierbereiches (3) enthält;
B Eindiffundieren des Dotierstoffes in die Halbleiterschicht durch Wärmeeinwirkung;
wobei vor Verfahrensschritt A in einem Verfahrensschritt A0 eine Passivierungsschicht (4) mittelbar oder unmittelbar auf eine Oberfläche der Halbleiterschicht aufgebracht wird, in Verfahrensschritt A die Dotierschicht mittelbar oder unmittelbar auf die Passivierungsschicht (4) aufgebracht wird und in Verfahrensschritt B der Dotierstoff aus der Dotierschicht durch die Passivierungsschicht (4) hindurch in die Halbleiterschicht eingebracht wird,
wobei die Passivierungsschicht (4) mittels eines chemischen und/oder physikalischen Abscheideverfahrens aufgebracht wird,
der Dotierstoff ein Dotierstoff aus der Gruppe Bor, Phosphor, Gallium, Arsen oder Indium ist und
die Passivierungsschicht (4) in Verfahrensschritt A0 mit einer Dotierstoffkonzentration kleiner 5x10¹⁹ cm⁻³ und die Dotierschicht in Verfahrensschritt A mit einer Dotierstoffkonzentration größer 10²⁰ cm⁻³ ausgebildet wird,
wobei die Dotierschicht als integraler Bestandteil der Solarzelle ausgebildet wird und
wobei eine Schichtstruktur bestehend aus Passivierungsschicht und Dotierschicht zur Verbesserung der optischen Eigenschaften der Solarzelle angepasst wird.

2. Verfahren nach Anspruch 1,
**dadurch gekennzeichnet,**
**dass** Dotierschicht und Passivierungsschicht (4) aus unterschiedlichen Materialien ausgebildet werden.

3. Verfahren nach einem der vorangegangenen Ansprüche,
**dadurch gekennzeichnet,**
**dass** Dotierschicht als Aluminiumoxidschicht, Siliziumoxidschicht, Siliziumnitridschicht, Aluminiumnitridschicht, Siliziumcarbidschicht, Siliziumoxynitridschicht oder amorphe Siliziumschicht ausgebildet ist.

4. Verfahren nach einem der vorangegangenen Ansprüche,
**dadurch gekennzeichnet,**
**dass** die Dotierschicht mit einer Dicke im Bereich 1 nm bis 2000 nm, bevorzugt im Bereich 10 nm bis 500 nm ausgebildet wird.

5. Verfahren nach einem der vorangegangenen Ansprüche,
**dadurch gekennzeichnet,**
**dass** die Passivierungsschicht (4) als Aluminiumoxid, Siliziumoxid, Siliziumnitrid, Aluminiumnitrid, Siliziumcarbid oder Siliziumoxynitrid ausgebildet wird.

6. Verfahren nach einem der vorangegangenen Ansprüche,
**dadurch gekennzeichnet,**
**dass** die Passivierungsschicht (4) zumindest als geschlossene Atomlage, vorzugsweise mit einer Dicke kleiner 500 nm, bevorzugt kleiner 50 nm, insbesondere bevorzugt mit einer Dicke kleiner 10 nm ausgebildet wird.

7. Verfahren nach einem der vorangegangenen Ansprüche,
**dadurch gekennzeichnet,**
**dass** die Passivierungsschicht (4) und gegebenenfalls weitere, zwischen Halbleiterschicht und Dotierungsschicht (2) aufgebrachte Schichten eine Gesamtdicke kleiner 500 nm, bevorzugt kleiner 50 nm, weiter bevorzugt kleiner 10 nm aufweisen.

8. Verfahren nach einem der vorangegangenen Ansprüche,
**dadurch gekennzeichnet,**
**dass** die Passivierungsschicht (4) unmittelbar auf die Halbleiterschicht und/oder die Dotierschicht unmittelbar auf die Passivierungsschicht (4) aufgebracht wird.

9. Verfahren nach einem der vorangegangenen Ansprüche,
**dadurch gekennzeichnet,**
**dass** das Abscheiden von Passivierungs- und der Dotierschicht in einer Prozesskammer in situ erfolgt.

10. Verfahren nach Anspruch 9,
**dadurch gekennzeichnet,**
**dass** in der Prozesskammer in situ zusätzlich mindestens eine Seite der Halbleiterschicht texturiert wird, insbesondere vor Abscheiden der Passivierungsschicht (4) texturiert wird.

11. Verfahren nach einem der vorangegangenen Ansprüche,
**dadurch gekennzeichnet,**
**dass** Eindiffundieren in Verfahrensschritt B in einem offenen System, insbesondere in einem Inline-Ofen erfolgt.

12. Verfahren nach einem der vorangegangenen Ansprüche,
**dadurch gekennzeichnet,**
**dass** auf einer Vorder- und auf einer Rückseite der Halbleiterschicht jeweils in Verfahrensschritt A0 eine Passivierungsschicht (4) und in Verfahrensschritt A eine Dotierschicht aufgebracht wird, vorzugsweise, dass die Dotierschicht auf der Vorderseite und die Dotierschicht auf der Rückseite unterschiedliche Dotierstoffe aufweisen.

13. Verfahren nach einem der vorangegangenen Ansprüche,
**dadurch gekennzeichnet,**
**dass** in Verfahrensschritt B das Eindiffundieren durch globales Erwärmen der Schichtstruktur umfassend zumindest Halbleiterschicht, Passivierungsschicht (4) und Dotierschicht erfolgt, vorzugsweise,
**dass** zusätzlich ein lokal selektives Eindiffundieren erfolgt, insbesondere durch lokales Erwärmen.

14. Verfahren nach einem der vorangegangenen Ansprüche,
**dadurch gekennzeichnet,**
**dass** in Verfahrensschritt B während des globalen Erwärmens in O₂ oder H₂O-haltiger Atmosphäre ein passivierendes Siliziumdioxid auf der nicht beschichteten Oberfläche der Halbleiterschicht aufgewachsen wird.

## Claims

1. Method for creating a doped region (3) in a semiconductor layer of a photovoltaic solar cell,
comprising the following method steps:
A application of a doping layer to the semiconductor layer, which doping layer contains at least one dopant for creating the doped region (3);
B diffusion of the dopant into the semiconductor layer by the action of heat;
wherein, before method step A, in a method step A0 a passivation layer (4) is applied indirectly or directly to a surface of the semiconductor layer, in method step A the doping layer is applied indirectly or directly to the passivation layer (4) and in method step B the dopant from the doping layer is introduced through the passivation layer (4) into the semiconductor layer,
wherein the passivation layer (4) is applied by means of a chemical and/or physical deposition process,
the dopant is a dopant from the group boron, phosphorus, gallium, arsenic or indium and
the passivation layer (4) in method step A0 is formed with a dopant concentration of less than 5x10¹⁹ cm⁻³ and the doping layer in method step A is formed with a dopant concentration greater than 10²⁰ cm⁻³,
wherein the doping layer is formed as an integral component of the solar cell and
wherein a layer structure consisting of passivation layer and doping layer is customised to improve the optical properties of the solar cell.

2. Method according to claim 1,
**characterised in that**
doping layer and passivation layer (4) are formed from different materials.

3. Method according to either one of the preceding claims,
**characterised in that**
the doping layer is in the form of an aluminium oxide layer, silicon oxide layer, silicon nitride layer, aluminium nitride layer, silicon carbide layer, silicon oxynitride layer or amorphous silicon layer.

4. Method according to any one of the preceding claims,
**characterised in that**
the doping layer is formed with a thickness in the range of from 1 nm to 2000 nm, preferably in the range of from 10 nm to 500 nm.

5. Method according to any one of the preceding claims, **characterised in that**
the passivation layer (4) is formed as aluminium oxide, silicon oxide, silicon nitride, aluminium nitride, silicon carbide or silicon oxynitride.

6. Method according to any one of the preceding claims,
**characterised in that**
the passivation layer (4) is formed at least as a closed atomic layer, preferably with a thickness of less than 500 nm, preferably less than 50 nm, especially preferably with a thickness of less than 10 nm.

7. Method according to any one of the preceding claims,
**characterised in that**
the passivation layer (4) and optionally further layers applied between semiconductor layer and doping layer (2) have a total thickness of less than 500 nm, preferably less than 50 nm, more preferably less than 10 nm.

8. Method according to any one of the preceding claims,
**characterised in that**
the passivation layer (4) is applied directly to the semiconductor layer and/or the doping layer is applied directly to the passivation layer (4).

9. Method according to any one of the preceding claims,
**characterised in that**
the deposition of the passivation layer and the doping layer is effected *in situ* in a process chamber.

10. Method according to claim 9,
**characterised in that**
in addition, at least one side of the semiconductor is textured *in situ* in the process chamber, especially being textured before deposition of the passivation layer (4).

11. Method according to any one of the preceding claims,
**characterised in that**
diffusion in method step B is effected in an open system, especially in an in-line furnace.

12. Method according to any one of the preceding claims,
**characterised in that**
in method step A0 a passivation layer (4) and, in method step A, a doping layer are each applied to a front side and to a rear side of the semiconductor layer; preferably, the doping layer on the front side and the doping layer on the rear side have different dopants.

13. Method according to any one of the preceding claims,
**characterised in that**
in method step B the diffusion is effected by global heating of the layer structure comprising at least semiconductor layer, passivation layer (4) and doping layer; preferably, in addition, locally selective diffusion is effected, especially by local heating.

14. Method according to any one of the preceding claims,
**characterised in that**
in process step B, during the global heating in O₂ or an H₂O-containing atmosphere a passivating silicon dioxide is grown on the non-coated surface of the semiconductor layer.

## Revendications

1. Procédé pour générer une zone de dopage (3) dans une couche semi-conductrice d'une cellule solaire photovoltaïque, comprenant les étapes de procédé suivantes :
A dépôt d'une couche de dopage sur la couche semi-conductrice, laquelle couche de dopage contient au moins un agent de dopage pour produire la zone de dopage (3) ;
B diffusion de l'agent de dopage dans la couche semi-conductrice sous l'action de la chaleur ;
dans lequel, avant l'étape de procédé A, une couche de passivation (4) est appliquée indirectement ou directement sur une surface de la couche semi-conductrice dans une étape de procédé A0, à l'étape de procédé A, la couche de dopage est appliquée indirectement ou directement sur la couche de passivation (4) et à l'étape de procédé B l'agent de dopage de la couche de dopage est introduit dans la couche semi-conductrice à travers la couche de passivation (4),
dans lequel la couche de passivation (4) est appliquée par un procédé de dépôt chimique et/ou physique,
l'agent de dopage est un agent de dopage appartenant au groupe constitué par le bore, le phosphore, le gallium, l'arsenic ou l'indium et
la couche de passivation (4) est formée à l'étape de procédé A0 avec une concentration d'agent de dopage inférieure à 5x10¹⁹ cm⁻³ et la couche de dopage est formée à l'étape de procédé A avec une concentration d'agent de dopage supérieure à 10²⁰ cm⁻³,
dans lequel la couche de dopage est formée comme partie intégrante de la cellule solaire et
dans lequel une structure en couches constituée de la couche de passivation et de la couche de dopage est appropriée à améliorer les propriétés optiques de la cellule solaire.

2. Procédé selon la revendication 1,
**caractérisé en ce que** la couche de dopage et la couche de passivation (4) sont formées de matériaux différents.

3. Procédé selon l'une des revendications précédentes,
**caractérisé en ce que** la couche de dopage est réalisée sous la forme d'une couche d'oxyde d'aluminium, d'une couche d'oxyde de silicium, d'une couche de nitrure de silicium, d'une couche de nitrure d'aluminium, d'une couche de carbure de silicium, d'une couche d'oxynitrure de silicium ou d'une couche de silicium amorphe.

4. Procédé selon l'une des revendications précédentes,
**caractérisé en ce que** la couche de dopage est formée avec une épaisseur dans la plage de 1 nm à 2000 nm, de préférence dans la plage de 10 nm à 500 nm.

5. Procédé selon l'une des revendications précédentes,
**caractérisé en ce que** la couche de passivation (4) est formée d'oxyde d'aluminium, d'oxyde de silicium, de nitrure de silicium, de nitrure d'aluminium, de carbure de silicium ou d'oxynitrure de silicium.

6. Procédé selon l'une des revendications précédentes,
**caractérisé en ce que** la couche de passivation (4) est réalisée au moins sous la forme d'une couche d'atomes fermée, de préférence avec une épaisseur inférieure à 500 nm, de préférence inférieure à 50 nm, en particulier de préférence avec une épaisseur inférieure à 10 nm.

7. Procédé selon l'une des revendications précédentes,
**caractérisé en ce que** la couche de passivation (4) et, le cas échéant, d'autres couches appliquées entre la couche semi-conductrice et la couche de dopage (2) présentent une épaisseur totale inférieure à 500 nm, de préférence inférieure à 50 nm, plus préférentiellement inférieure à 10 nm.

8. Procédé selon l'une des revendications précédentes,
**caractérisé en ce que** la couche de passivation (4) est appliquée directement sur la couche semi-conductrice et/ou la couche de dopage directement sur la couche de passivation (4).

9. Procédé selon l'une des revendications précédentes,
**caractérisé en ce que** le dépôt de la couche de passivation et de la couche de dopage a lieu in situ dans une chambre de traitement.

10. Procédé selon la revendication 9,
**caractérisé en ce qu'**en outre au moins une face de la couche semi-conductrice est texturée in situ dans la chambre de traitement, en particulier avant le dépôt de la couche de passivation (4).

11. Procédé selon l'une des revendications précédentes,
**caractérisé en ce que** la diffusion à l'étape de procédé B a lieu dans un système ouvert, en particulier dans un four en ligne.

12. Procédé selon l'une des revendications précédentes,
**caractérisé en ce qu'**à l'étape de procédé A0 une couche de passivation (4) et à l'étape de procédé A une couche de dopage est appliquée respectivement sur une face avant et sur une face arrière de la couche semi-conductrice, de préférence **en ce que** la couche de dopage sur la face avant et la couche de dopage sur la face arrière présentent des agents de dopage différents.

13. Procédé selon l'une des revendications précédentes,
**caractérisé en ce qu'**à l'étape de procédé B, la diffusion a lieu par chauffage global de la structure en couches comprenant au moins la couche semi-conductrice, la couche de passivation (4) et la couche de dopage, de préférence **en ce que**, en outre, une diffusion localement sélective a lieu, en particulier par chauffage local.

14. Procédé selon l'une des revendications précédentes,
**caractérisé en ce que**, à l'étape de procédé B, pendant le chauffage global dans une atmosphère contenant O₂ ou H₂O, on fait croître un dioxyde de silicium passivant sur la surface non revêtue de la couche semi-conductrice.
